Europäisches Patentamt

**European Patent Office**

Office européen des brevets

(19)

(11) Publication number: **0 068 692**
A2

## (12) EUROPEAN PATENT APPLICATION

(21) Application number: 82303037.4

(22) Date of filing: 11.06.82

(51) Int. Cl.³: **H 01 L 31/10**

(30) Priority: 01.07.81 GB 8120376

(43) Date of publication of application: 05.01.83
Bulletin 83/1

(84) Designated Contracting States: **DE FR NL**

(71) Applicant: **The Secretary of State for Defence in Her Britannic Majesty's Government of The United Kingdom of Great Britain and, Northern Ireland Whitehall, London SW1A 2HB (GB)**

(72) Inventor: **Dean, Anthony Brian, 2 Purlieu Cottages Upper Colwall, Near Malvern Worcestershire (GB)**
Inventor: **White, Anthony Michael, 3 Guarlford Road, Malvern Worcestershire (GB)**

(74) Representative: **Edwards, John Brian et al, Procurement Executive Ministry of Defence Patents 1 A (4), Room 2014 Empress State Building Lillie Road, London SW6 1TR (GB)**

(54) Photodetector devices.

(57) A photo detector comprising a piece of detector material (1) and electrodes (2, 3, 4) for connecting the detector into a circuit is characterised by a double passivating layer (6, 7) over a radiation collecting surface. This double layer comprises a first layer (6) less than 250 Å thick next to the detector material and a second thicker layer (7). One layer is an accumulating layer whilst the other is a depleting layer. The amount of conduction and valency band bending at the detector material passivation layer interface can be tailored by varying the thickness of the first passivating layer. For n-type $Cd_xHg_{1-x}Te$ detector material the first layer may be an accumulating layer of anodic oxide typically 80 Å thick and the second layer may be ZnS typically of 1,000 Å thickness.

## PHOTODETECTOR DEVICES

This invention relates to photodetector devices in which carriers are generated in a material when illuminated by electro magnetic radiation.

One use of photo detectors is in infra red (thermal) imaging systems where the thermal image of a scene is scanned across a detector whose output is used to drive a visual display. The most sensitive detectors presently available are those made of the compound $Cd_xHg_{1-x}Te$ and operating at liquid nitrogen temperature $(70°K)$.

U.K. Patent Specification No. 1,488,258 describes a CdHgTe (C.M.T.) detector having the form of an elongate strip of C.M.T. with electrodes at each end to provide an ambipolar carrier drift. Mercury evaporates from the surface of C.M.T. also the surface oxides readily. To prevent this surface deterioration C.M.T. detector surfaces are passivated e.g. by a thick (typically 1,000Å) layer of anodic oxide. This also has the effect of improving minority carrier lifetime which is desirable. Unfortunately the oxide is accumulating on n-type material i.e. attracts majority carriers to the surface, resulting in a lowered surface resistance with consequential surface current and heating effects. This increases the thermal load on the detector cooling system.

A depleting (inverting) type of passivating layer could be used on the C.M.T. This would reduce power consumption and heating but would reduce the carrier lifetime to unacceptable levels.

Various monolithic devices e.g. detectors plus metal insulator semiconductor devices have been built using CdHgTe as described in:- International Electron Devices Meeting, December 1978, I.E.E.E. pp. 496-500; App. Phys. Lett. 32(7) 1 April 1978, pp 434/6; I.E.E.E. Trans. on Electron Devices, Vol. ED 27 No. 3, March 1980, pp 591/595.

According to this invention a photodetector comprises a piece of material sensitive to electromagnetic radiation and electrodes for connecting the detector into a circuit, characterised by a thin, less than 250Å thick, layer of a first passivating material next to the detector material, and a second, thicker, layer of a second passivating material over the first layer, one layer being an accumulating layer whilst the other is a depleting layer.

The detector may be photoconductive or photovoltaic detector of visible or infra red radiation.

The detector material may be the alloy $Cd_x Hg_{1-x} Te$ and may be n-type or p-type. The first passivating layer may be a layer of anodic oxide. The second layer is of opposite type to the first layer and may be of zinc sulfide (ZnS).

Alternative detector materials are lead tin telluride, indium antimonide, gallium arsenide, gallium aluminium arsenide, indium arsenide, cadmium telluride, indium phosphide, and alloys of these materials.

The passivating layers may be of native oxides and other insulating dielectrics which have the appropriate inversion/depletion/accumulation characteristics.

The invention will now be described, by way of example only, with reference to the accompanying drawings in which:-

Figure 1 shows a photo conductive detector;

Figure 2a, b, c show bending of conduction and valency bands for different types of passivating layers used on detectors shown in Figure 1.

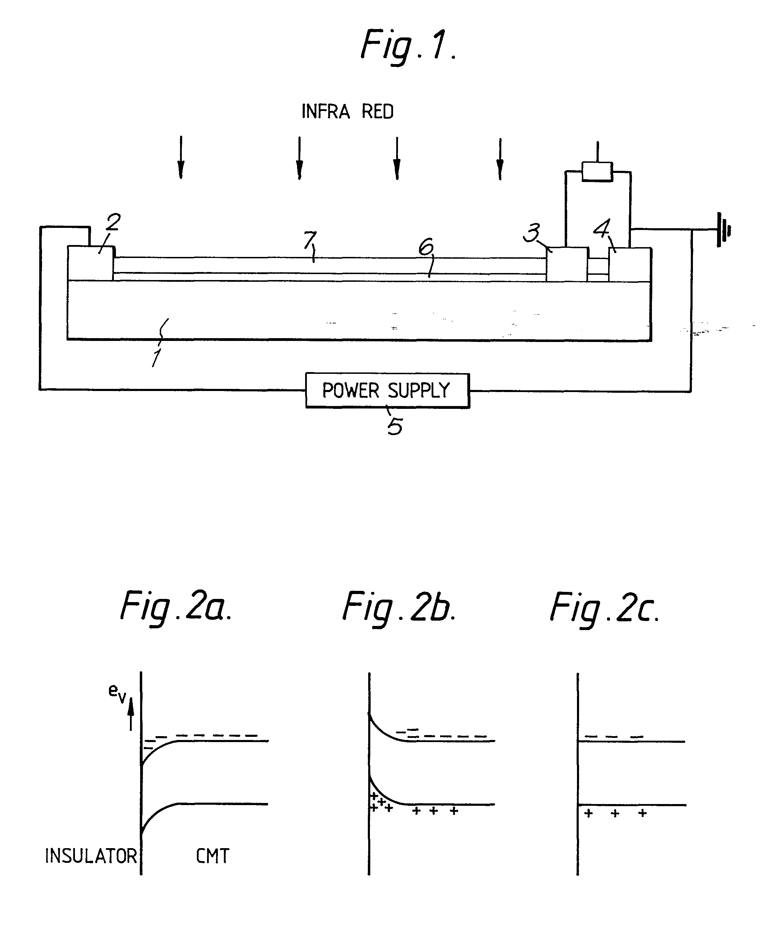

As seen in Figure 1 an infra red photo detector comprises a strip 1 of n-type $Cd_xHg_{1-x}Te$ (C.M.T.) material with electrodes 2, 3, 4 formed on the surface. Two end electrodes 2, 4 provide a bias via a power supply 5 for the purpose described in U.K. Patent No. 1,488,258. Two adjacent electrodes 3, 4 form a read out pair. The electrodes may be formed by evaporation of gold or aluminium. A thin anodic oxide layer 6 is formed on the polished surfaces of the C.M.T. 1 to a thickness of about $80\overset{o}{A}$. This layer 6 may be formed by connecting the strip 1 as the anode in an electrolyte solution, e.g. potassium hydroxide (KOH), borax $(Na_2N_4O_7.10H_2O)$-ethylene glycol solution etc., as described in e.g. U.S. Patent No. 3,977,018. A thick zinc sulphide (ZnS) layer 7 is formed on the oxide layer to a depth of about $1,000\overset{o}{A}$ e.g. by low temperature sputtering, or evaporation.

When the strip 1 is illuminated with infra red radiation ambipolar carriers are generated and are swept to the read out electrodes 3, 4 by the bias voltage to provide a measure of the incident infra red radiation as described in U.K. Patent No. 1,488,258, and U.S.A. Patent No. 3,995,159.

The effect of the oxide and ZnS layers 6, 7 on the n-type C.M.T. strip 1 is explained with reference to Figure 2a, b, c. A thick e.g. greater than about 200Å, typically 1,000Å, layer of anodic oxide layer is accumulating i.e. it attracts electrons to the insulator-C.M.T. interface. This is shown in Figure 2a where the conduction and valency bands bend downwards. Electrons preferentially move to the interface whilst holes move into the bulk of the C.M.T. As a result when bias is applied to the detector, electron flow occurs at the interface with a consequential Joule heating whilst holes enjoy an increased lifetime. This is described in J.Phys.D App.Phys 14(1981) L1-3.

Figure 2b shows the band bending that occurs with a thick (1,000Å) ZnS layer. This causes a depletion of majority carriers (electrons) from the interface and increased concentration of holes. The depletion of electrons reduces the power consumption but reduces the hole lifetime which is undesirable.

Double passivating layers have been used before but always with a thick first layer to produce the pasivating effect followed by a different layer to give a greater mechanical and electrical strength. This results in an interface condition (accumulation or depletion) that is governed only by the first layer, the second layer having no effect.

With the present invention, however, the first passivating layer 6 is made sufficiently thin that it affects but not entirely masks the nature of the second layer 7. Thus, for oxide followed by ZnS layers passivation of n-type C.M.T., the insulator C.M.T. interface can be varied from inverting to accumulating as the oxide thickness is increased from near zero to about 100Å or more. This means the amount and direction of band bending can be tailored to suit any requirement.

0068692

For a C.M.T. detector the amount of accumulation needs to be reduced to reduce Joule heating but without decreasing hole lifetime too much. A suitable compromise is with an 80Å thick oxide layer followed by a greater than about 500Å thick ZnS layer. This reduces the band bending, Figure 2c, which enables a precise compromise between surface shunt conductance and hole lifetime to be gained, dependent to some extent on the intial methods of surface preparation.

In addition to allowing a tailoring of the band bending the thin anodic oxide layer also restricts the drift in device parameters due to defect and impurity motion frequently found in devices with thick anodic layers.

Claims:

1. A photodetector comprising a piece of material (1) sensitive to electromagnetic radiation and electrodes (2, 3, 4) for connecting the detector into a circuit, characterised by a thin, less than 250Å thick, layer of a first passivating material (6) next to the detector material (1), and a second, thicker, layer (7) of a second passivating material over the first layer, one layer being an accumulating layer whilst the other is a depleting layer.

2. The photodetector of claim 1 wherein the detector material (1) is a material selected from the group comprising $Cd_xHg_{1-x}Te$, lead tin telluride, indium antimonide, gallium arsenide, gallium aluminium arsenide, indium arsenide, cadmium telluride, indium phosphide, and alloys of these materials.

3. The photodetector of claim 2 wherein the first passivating layer (6) is a layer of an oxide of the detector material.

4. The photodetector of claim 2 wherein the detector material (1) is $Cd_xHg_{1-x}Te$ and the first passivating layer (6) is a layer of anodic oxide.

5. The photodetector of claim 4 wherein the second passivating layer (7) is a layer of zinc sulfide.

6. The photodetector of claim 4 wherein the $Cd_xHg_{1-x}Te$ is n-type.

7. The photodetector of claim 4 wherein the $Cd_xHg_{1-x}Te$ is p-type.

8. The photodetector of claim 4 wherein the anodic oxide layer (6) is less than 100Å thick.

9. The photodetector of claim 5 wherein the zinc sulfide layer (7) is greater than 500Å thick.

# Fig.1.

INFRA RED

POWER SUPPLY

# Fig.2a.

INSULATOR | CMT

# Fig.2b.

# Fig.2c.